# EUROPÄISCHE PATENTSCHRIFT

(11) **EP 0 607 868 B1**
(45) Veröffentlichungstag und Bekanntmachung des Hinweises auf die Patenterteilung: **05.03.1997**
(21) Anmeldenummer: 94100425.1
(22) Anmeldetag: 13.01.1994
(51) Int. Cl.: H01S 3/06, H04B 10/14

(54) **Optische Sendeeinrichtung und Nachichtenübertragungssystem**
Optical transmitter and communication system
Transmetteur optique et système de communication

(30) Priorität: 16.01.1993 DE 4301031
(43) Veröffentlichungstag der Anmeldung: 27.07.1994
(73) Patentinhaber: Alcatel SEL Aktiengesellschaft, D-70435 Stuttgart (DE)
(72) Erfinder: Schmuck, Harald, D-70499 Stuttgart (DE)
(74) Vertreter: Schätzle, Albin, Dipl.-Phys.

(56) Entgegenhaltungen:
- EP-A- 0 461 380
- APPLIED PHYSICS LETTERS., Bd.60, Nr.25, 22. Juni 1992, NEW YORK US Seiten 3090 - 3092, XP000280693 J.W. DAWSON ET AL. 'Co-lasing in an electrically tunable erbium-doped fiber laser'
- ELECTRONICS LETTERS., Bd.28, Nr.5, 27. Februar 1992, STEVENAGE GB Seiten 461 - 463, XP000292686 H. OKAMURA ET AL. 'Simultaneous oscillation of wavelength-tunable, singlemode lasers using an Er-doped fibre amplifier'
- ELECTRONICS LETTERS., Bd.27, Nr.22, 24. Oktober 1991, STEVENAGE GB Seiten 2033 - 2035, XP000265995 D. CULVERHOUSE ET AL. 'Stimulated Brillouin scattering ring resonator laser for SBS gain studies and microwave generation'

## Beschreibung

Die Erfindung betrifft eine optische Sendeeinrichtung sowie gemäß dem Oberbegriff des Anspruchs 1 bzw. 2.

Aus der DE-A-40 19 224 ist ein Funk-Nachrichtenübertragungssystem, insbesondere zellulares Mobilfunksystem, bekannt, daß zwei optische Sender unterschiedlicher Frequenz aufweist. Durch Differenzbildung der beiden Frequenzen wird eine Trägerfrequenz geschaffen. Zur Einhaltung der Frequenzdifferenz ist eine Frequenzregelungs-Einrichtung vorgesehen. Nachteilig ist der Einsatz zweier optischer Einrichtungen, sowie die relativ aufwendige Frequenzregelungs-Einrichtung.

Aus der Literaturstelle Electronics Letters, 27th February 1992, Vol. 28, No. 5, Seite 461 "Simultaneous Oscillation of Wavelength-Tunable, Singlemode Lasers using an Er-Doped Fibre Amplifier" ist es bekannt, einen Faser-Ring-Laser mit einem By-Pass zur Erzeugung mehrerer Frequenzen zu verwenden. Auf eine Mikrowellenerzeugung, insbesondere im Hinblick auf eine Frequenzdifferenzbildung, geht diese Literaturstelle nicht ein.

Der Erfindung liegt die Aufgabe zugrunde, eine optische Sendeeinrichtung zu schaffen, die einen einfachen Aufbau besitzt. Ferner soll sie eine stabile Zwischenfrequenzlage ohne den Einsatz aufwendiger Mittel, beispielsweise eines Regelkreises oder dergleichen ermöglichen.

Diese Aufgabe wird erfindungsgemäß durch die im Anspruch 1 angegebenen Merkmale gelöst.

Anspruch 2 bezieht sich auf ein optisches Nachrichtenübertragungssystem mit einer solchen Sendeeinrichtung.

Lediglich eine Laser-Lichtquelle, nämlich der Faser-Ring-Laser, muß eingesetzt werden, um aufgrund der polarisationsempfindlichen Mittel die orthogonalen Eigenmoden zu erstellen, die einen festen Frequenzabstand zueinander haben. Da dieser Frequenzabstand konstant ist, sind aufwendige Regelkreise -wie sie im Stand der Technik bekannt sind- nicht erforderlich. Die Zwischenfrequenz-Einrichtung weist zur Selektion der beiden zu überlagernden Lichtwellen die optische Filteranordnung auf, wobei die polarisationsempfindliche Filteranordnung selektiv im Hinblick auf jede der beiden Polarisations-Eigenmoden wirkt. Damit ist die stabile Zwischenfrequenzlage und somit ein frequenzstabiles Mikrowellen-Signal mit einfachen Mitteln geschaffen. Durch die Aufspaltung in orthogonale Eigen-moden mit polarisationsempfindlichen Mitteln werden zwei unabhängige Ringresonatoren gebildet.

Nach einer Weiterbildung der Erfindung sind die polarisationsempfindlichen Mittel als mindestens ein polarisationserhaltender Lichtwellenleiter des Faser-Ringes ausgebildet. Unter diesem Lichtwellenleiter sind alle im Ring vorhandenen Fasern, Faserkoppler usw. zu verstehen, das heißt, sämtliche Bauteile wirken polarisationserhaltend. Vorzugsweise weist einer der Lichtwellenleiter eine Dotierung, insbesondere eine Erbium-Dotierung (Er³⁺), auf.

Die optische Filteranordnung besitzt vorzugsweise zwei Filter, die in Parallelschaltung im Faser-Ring angeordnet sind. Es ist jedoch auch möglich, eine optische Filteranordnung zu verwenden, die ein Filter mit einem freien Spektralbereich (FSR) aufweist, der der Zwischenfrequenz Δf entspricht.

Nach einer Weiterbildung der Erfindung ist vorgesehen, daß der optischen Filteranordnung ein im Faser-Ring liegendes Vorfilter zugeordnet ist, innerhalb dessen Bandbreite die beiden Durchlaßbereiche der Filteranordnung liegen. Das Vorfilter bildet somit eine Art "Grobfilter" um aus der Vielzahl der Moden des Lasers einen bestimmten Bereich auszuwählen und die übrigen Moden auszublenden. Innerhalb dieses Bereichs wählt dann die optische Filteranordnung zwei voneinander beabstandet liegende Moden aus, deren Frequenzabstand Δf der Frequenz des Mikrowellensignals entspricht.

Sofern keine polarisationserhaltende Faser bei dem Faser-Ring-Laser eingesetzt wird, ist es erforderlich, dort einen Polarisationssteller anzuordnen. Dies ist beispielsweise erforderlich, wenn im Faser-Ring eine Standard-Single-Mode-Faser zum Einsatz kommt.

Vorzugsweise ist ferner im Faserring ein polarisationsunempfindlicher Isolator angeordnet, der im Faserring die Lichtwellenrichtung bestimmt.

Schließlich weist der Faserring vorzugsweise ein wellenlängenabhängiges Vestärkungsanpassungselement auf. Dies kann beispielsweise als Dämpfungsglied ausgebildet sein. Es dient dazu, die beiden selektierten Moden gleichmäßig anschwingen zu lassen um zu verhindern, daß eine Mode beim Anschwingen eine größere Amplitude als die andere erhält, was dazu führen könnte, daß die Mode mit größerer Amplitude weiterhin dominieren würde, so daß die andere Mode nicht im gleichen Umfange zur Verfügung steht. Das Verstärkungsanpassungselement schaft also einen Ausgleich.

Die Zeichnungen veranschaulichen die Erfindung anhand mehrerer Ausführungsbeispiele und zwar zeigt:
- Figur 1: ein Diagramm,
- Figur 2: ein weiteres Diagramm,
- Figur 3: einen Faser-Ring-Laser mit Modulationseinrichtung,
- Figur 4: ein Ausführungsbeispiel eines optischen Mikrowellen-Generator.
- Figur 5: ein weiteres Ausführungsbeispiel eines optischen Mikrowellen-Generators,
- Figur 6: ein Diagramm und
- Figur 7: ein letztes Ausführungsbeispiel eines optischen Mikrowellen-Generators.

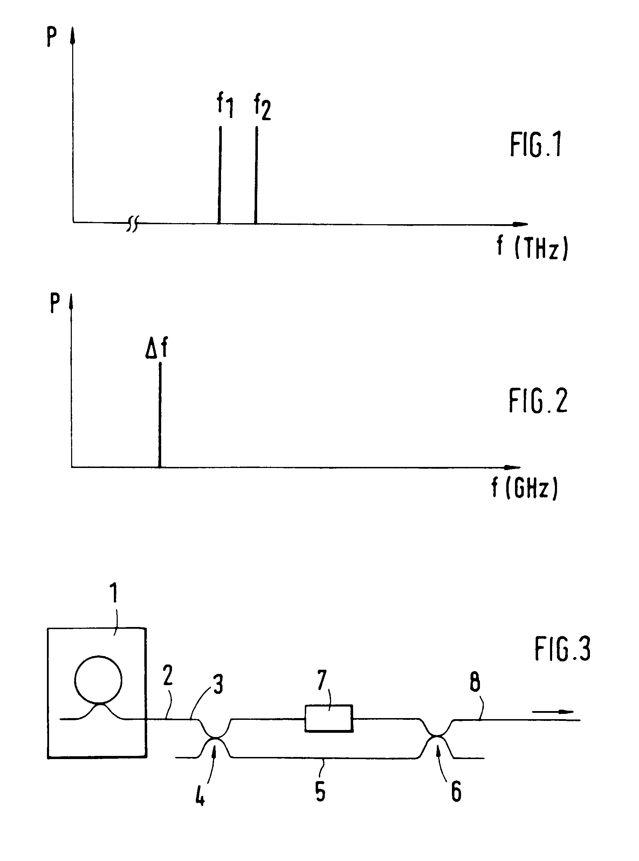

Die Figur 1 zeigt ein Diagramm, anhand dessen das Funktionspinzip des erfindungsgemäßen optischen Mikrowellen-Generators erläutert werden soll. Auf der Ordinate ist die Ausgangsleistung eines Lasers und auf der Abszisse die Frequenz des Ausgangssignals aufgetragen. Da es sich um Lichtwellen handelt, liegt die Frequenz im Terraherzbereich (THz). Stellt der Laser eine erste Frequenz f₁ sowie eine davon abweichende zweite Frequenz f₂ zur Verfügung und wird eine Frequenzdifferenz Δf= f₂ - f₁ gebildet, so ergibt sich ein "Zwischenfrequenz-Signal", das ein Mikrowellen-Signal darstellt und beispielsweise im GHz-Bereich (GHz) liegt. In der Figur 2 ist die Frequenzdifferenz Δf dargestellt, die beispielsweise 60 GHz betragen kann. Diese Frequenz wird als Trägerfrequenz verwendet. Das Trägersignal wird z.B. bei einem zellularen Mobilfunksystem von einer Zentralen Einheit über einen optischen Lichtwellenleiter einem optisch-elektrisch Wandler zugeführt, der in einer Zelle angeordnet ist,und durch die elektrisch-optische Wandlung ein elektrisches Mikrowellensignal erzeugt. Dieses Mikrowellensignal kann gemäß Figur 3 moduliert werden. Hierzu ist ein Faser-Ring-Laser 1 vorgesehen, dessen Ausgang 2 über einen Lichtwellenleiter 3 auf einen polarisationsselektiven Koppler 4 wird. Der Koppler 4 steht über einen Lichtwellenleiter 5 mit einem weiteren polarisationsselektiven Koppler 6 in Verbindung. Parallel zum Lichtwellenleiter 5 liegt ein Lichtwellenleiter 2, in dem ein Modulator eingebunden ist, der eine Amplituden-, Frequenz-, oder Phasenmodulation vornimmt. Vom Koppler 6 geht ein Lichtwellenleiter 8 aus, der das modulierte Trägerfrequenzsignal aufweist.

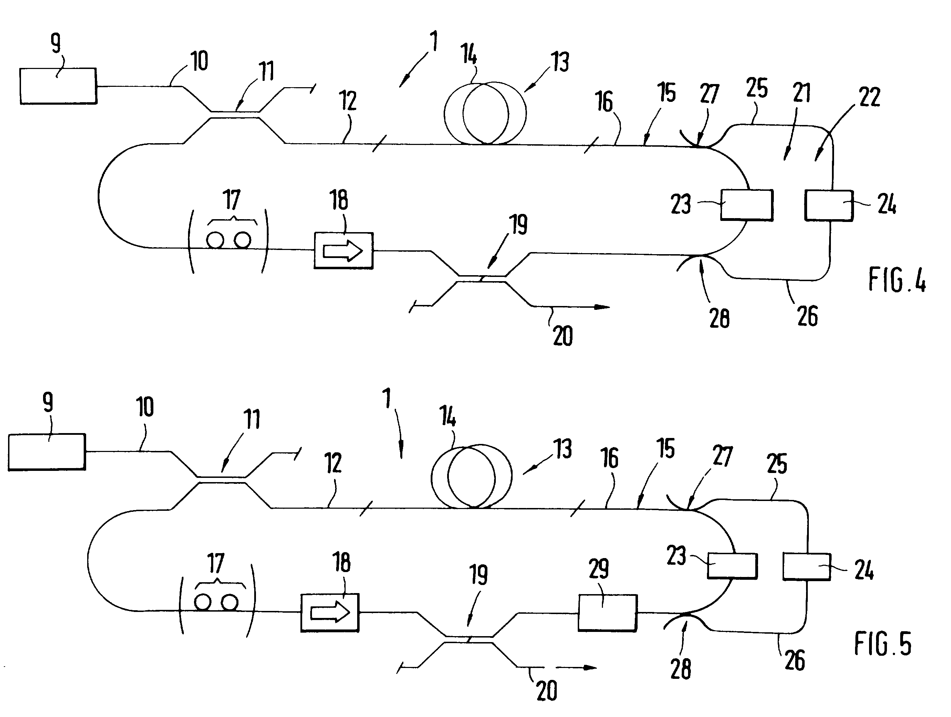

Im folgenden soll anhand der Figuren 4, 5 und 7 der in der Figur 3 mit 1 bezeichnete Faser-Ring-Laser näher erläutert werden.

Der Faser-Ring-Laser 1 der Figur 4 weist einen Pump-Laser 9 auf, der beispielsweise eine Wellenlänge v von 980 nm aufweist. Der Pump-Laser 9 steht über einen Lichtwellenleiter 10 und einem wellenlängenselektiven, polarisationserhaltenden Koppler 11 mit einem Faser-Ring 12 in Verbindung. Der Faser-Ring 12 weist einen frequenzbandbestimmenden Lichtwellenleiter 13 auf, der z.B. als Erbium dotierte Faser 14 (Er³⁺-dotierte Faser) ausgebildet ist. Ferner weist der Faserring 12 polarisationsempfindliche Mittel 15 auf, zu denen unter anderem der frequenzbandbestimmende Lichtwellenleiter 13 und auch ein Lichtwellenleiter 16 gehört. Beide Lichtwellenleiter 13 und 16 sind als polarisationserhaltende Lichtwellenleiter ausgebildet. Sofern nach einem anderen Ausführungsbeispiel keine polarisationserhaltenden Lichtwellenleiter, sondern z.B. Standard-Single-Mode-Fasern verwendet werden, befindet sich im Faser-Ring 12 ein Polarisationssteller 17. Diese Alternative ist in den Figuren 4, 5 und 7 durch Einklammern angedeutet. Unabhängig von der Ausführungsform befindet sich im Faserring 12 ferner ein optischer Isolator 18, der polarisationsunempfindlich ausgebildet ist, sowie ein Koppler 19, der ein Ausgangssignal auf einem Lichtwellenleiter 20 auskoppelt.

Ferner ist in die Faser des polarisationserhaltenden Lichtwellenleiters 16 eine optische Filteranordnung 21 eingeschaltet, die eine Zwischenfrequenz-Einrichtung 22 darstellt. Die Zwischenfrequenz-Einrichtung 22 weist ein erstes Filter 23 und zweites Filter 24 auf, wobei das zweite Filter 24 mittels polarisationserhaltenden Lichtwellenleitern 25 und 26 sowie polarisationserhaltenden Kopplern 27 und 28 zu dem ersten Filter 23 parallel geschaltet ist.

Im Betrieb regt der Pump-Laser 9 im Faser-Ring 12 Lichtwellen an, die aufgrund des optischen Isolators in vorgegebener Richtung "umlaufen", wobei aufgrund der Erbium-Dotierung zum Beispiel eine Wellenlänge v = 1550nm vorliegt. Die beiden Filter 23 und 24 wählen aus der vielzahl der longitudinalen Moden zwei Moden heraus, die einen Abstand voneinander aufweisen, welcher der gewünschten Zwischenfrequenz Δf entspricht. Dabei sind die eingesetzten polarisationserhaltenden Lichtwellenleiter 16 beziehungsweise 25 und 26 derart ausgebildet, daß sie orthogonale Eigenmoden anregen, wobei diese beiden Polarisations-Eigenmoden aufgrund der unterschiedlichen Berechnungsindices und der Resonanzbedingungen im Faser-Ring 12, sowie der Filter 23, 24 unterschiedliche Frequenzen aufweisen derart, daß ihre Frequenzdifferenz gerade der gewünschten Zwischenfrequenz entspricht. Auf diese Art und Weise wird ein Mikrowellen-Signal als Nutzsignal erzeugt.

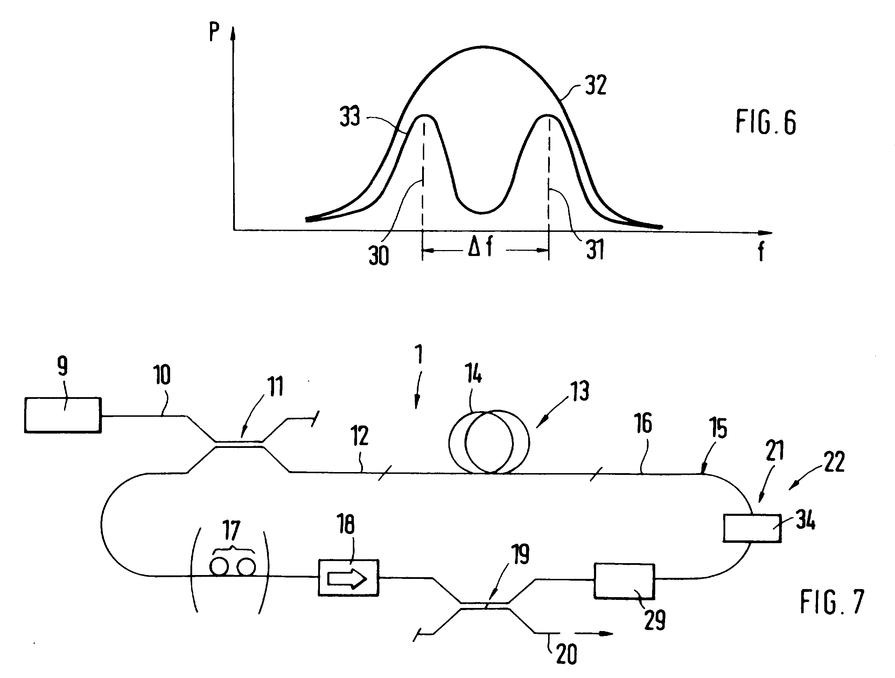

Das Ausführungsbeispiel der Figur 5 unterscheidet sich von dem der Figur 4 dadurch, daß in den Faser-Ring 12 zusätzlich ein Vorfilter 29 angeordnet ist, innerhalb dessen Bandbreite die beiden Durchlaßbereiche der Filteranordnung 21 liegen. Dies ist in dem Diagramm der Figur 6 verdeutlicht. Dort sind die beiden orthogonalen Eigenmoden 30 und 31 angedeutet, zwischen denen die Frequenzdifferenz f liegt. Das Vorfilter 29 hat die mit 32 bezeichnete Charakteristik, das heißt, aus der vielzahl der in der Figur 6 nicht dargestellten Moden wird ein Bereich ausgewählt, in dem die beiden Eigenmoden 30 und 31 liegen. Mittels der optischen Filteranordnung 21 werden dann die beiden Eigenmoden 30 und 31 aus dem bereits durch das Vorfilter 29 ausgewählten Bereich ausgewählt. Dies ist mittels der Charakteristik 33 in Figur 6 dargestellt.

Die Frequenzen f₁ und f₂, angeregt in den beiden orthogonalen Moden, werden vorzugsweise durch die Beschaffenheit der polarisationserhaltenden Lichtwellenleiter (z.B. durch voneinander abweichende effektive Brechungsindizes der Eigenmoden) und/oder durch Anpassung der Faser-Ringlänge geprägt, wobei sie in bezug auf ihre jeweilig zugeordnete Frequenz derart beschaffen sind, daß die Frequenzdifferenz f₂ - f₁ = Δf = der gewünschten Mikrowellen-Frequenz entspricht.

Auf diese Art und Weise ist mit einfachen Mitteln eine stabile Zwischenfrequenzlage erzielt.

Das in der Figur 7 dargestellte Ausführungsbeispiel unterscheidet sich von dem Ausführungsbeispiel der Figur 5 lediglich darin, daß anstelle der beiden Filter 23 und 24 der eine Zwischenfrequenz-Einrichtung 22 bildenden optischen Filteranordnung 21 nur ein Filter 34 eingesetzt ist, das jedoch die gleiche Charakteristik wie in der Figur 6 aufweist. Es liegt somit ein freier Spektralbereich FSR der Größe Δf vor.

In den Ausführungsbeispielen ist die Erfindung aus diskreten Elementen aufgebaut, sie kann aber auch ganz oder nur teilweise optisch integriert ausgeführt werden.

## Patentansprüche

1. Optische Sendeeinrichtung, bei der in einen Faser-Ring (12) ein mit Seltenerdionen dotiertes Faserstück (13), zwei optische Koppler (11, 19) und eine optische Filteranordnung (21) eingefügt sind, bei der der erste optische Koppler (11) von einem Pump-Laser (9) ausgesendetes Licht in den Faser-Ring (12) einkoppelt, bei der die optische Filteranordnung (21) zwei Durchlaßbereiche für unterschiedliche Frequenzen (f₁,f₂) hat, und bei der der zweite optische Koppler (19) von der optischen Filteranordnung (21) durchgelassenes Licht aus dem Faser-Ring (12) auskoppelt,
**dadurch gekennzeichnet**, daß im Faser-Ring (12) polarisationsempfindliche Mittel (15) angeordnet sind, die bezüglich der Polarisation orthogonale Eigenmoden (30, 31) erzeugen, wobei den Eigenmoden (30, 31) die genannten unterschiedlichen Frequenzen (f₁, f₂) zugeordnet sind, deren Differenzfrequenz einer im Mikrowellenbereich liegenden Zwischenfrequenz (Δf) entspricht.

2. Nachrichtenübertragungssystem, bei dem eine zentrale optische Sendeeinrichtung durch Lichtwellenleiter mit mindestens einer räumlich davon entfernten Funkstation verbunden ist, bei dem in der Funkstation ein optischer Empfänger vorhanden ist, der ein empfangenes optisches Signal in ein elektrisches Signal wandelt, das die Funkstation als Funksignal aussendet,
**dadurch gekennzeichnet**, daß die optische Sendeeinrichtung einen Faser-Ring (12) hat, in den ein mit Seltenerdionen dotiertes Faserstück (13), zwei optische Koppler (11, 19) und eine optische Filteranordnung (21) eingefügt sind, daß der erste optische Koppler (11) von einem Pump-Laser (9) ausgesendetes Licht in den Faser-Ring (12) einkoppelt, daß die optische Filteranordnung (21) zwei Durchlaßbereiche für unterschiedliche Frequenzen (f₁,f₂) hat, daß der zweite optische Koppler (19) von der optischen Filteranordnung (21) durchgelassenes Licht aus dem Faser-Ring (12) auskoppelt und daß im Faser-Ring (12) polarisationsempfindliche Mittel (15) angeordnet sind, die bezüglich der Polarisation orthogonale Eigenmoden (30, 31) erzeugen, wobei den Eigenmoden (30, 31) die genannten unterschiedlichen Frequenzen (f₁, f₂) zugeordnet sind, deren Frequenzdifferenz einer im Mikrowellenbereich liegenden Zwischenfrequenz (Δf) entspricht, die als Trägerfrequenz für das Funksignal dient.

3. Optische Sendeeinrichtung nach Anspruch 1 oder Nachrichtenübertragungssystem nach Anspruch 2,
dadurch gekennzeichnet, daß die polarisationsempfindlichen Mittel (15) mindestens ein polarisationserhaltender Lichtwellenleiter (11, 13, 16, 25, 26, 27, 28) des Faser-Rings (12) sind.

4. Optische Sendeeinrichtung nach Anspruch 1 oder Nachrichtenübertragungssystem nach Anspruch 2,
dadurch gekennzeichnet, daß der frequenzbandbestimmende Lichtwellenleiter (13) eine Dotierung, insbesondere eine Erbium-Dotierung (Er³⁺), aufweist.

5. Optische Sendeeinrichtung nach Anspruch 1 oder Nachrichtenübertragungssystem nach Anspruch 2,
dadurch gekennzeichnet, daß die optische Filteranordnung (21) zwei Filter (23, 24) aufweist, die in Parallelschaltung zueinander im Faser-Ring (12) angeordnet sind.

6. Optische Sendeeinrichtung nach Anspruch 1 oder Nachrichtenübertragungssystem nach Anspruch 2,
dadurch gekennzeichnet, daß die optische Filteranordnung (21) ein Filter (34) mit einem freien Spektralbereich (FST) aufweist, der der Differenz (Δf) der beiden Frequenzen (f₁, f₂) entspricht.

7. Optische Sendeeinrichtung nach Anspruch 1 oder Nachrichtenübertragungssystem nach Anspruch 2,
dadurch gekennzeichnet, daß der optischen Filteranordnung ein im Faser-Ring (12) liegendes Vorfilter (29) zugeordnet ist, innerhalb dessen Bandbreite die beiden Durchlaßbereiche der Filteranordnung (21) liegen.

8. Optische Sendeeinrichtung nach Anspruch 1 oder Nachrichtenübertragungssystem nach Anspruch 2,
dadurch gekennzeichnet, daß im Faser-Ring (12) ein Polarisationssteller (17) angeordnet ist.

9. Optische Sendeeinrichtung nach Anspruch 1 oder Nachrichtenübertragungssystem nach Anspruch 2,
dadurch gekennzeichnet, daß im Faser-Ring (12) ein polarisations-unempfindlicher Isolator (18) angeordnet ist.

10. Optische Sendeeinrichtung nach Anspruch 1 oder Nachrichtenübertragungssystem nach Anspruch 2,
dadurch gekennzeichnet, daß im Faser-Ring (12) ein wellenlängenabhängiges Verstärkungsanpassungselement angeordnet ist.

## Claims

1. An optical transmitter wherein a rare-earth-doped section of fiber (13), two optical couplers (11, 19), and an optical filter arrangement (21) are inserted in a fiber ring (12), wherein the first optical coupler (11) couples light emitted by a pump laser (9) into the fiber ring (12), wherein the optical filter arrangement (21) has two passbands for different frequencies (f₁, f₂), and wherein the second optical coupler (19) couples light transmitted by the optical filter arrangement (21) from the fiber ring (12),
**characterized in** that the fiber ring (12) includes polarization-sensitive means (15) which excite natural modes (30, 31) orthogonal with respect to the polarization, the natural modes (30, 31) being assigned said different frequencies (f₁, f₂), whose difference corresponds to an intermediate frequency (Δf) lying in the microwave region.

2. A communications system wherein a central optical transmitter is connected by an optical fiber link to at least one remote radio station, and wherein the radio station comprises an optical receiver which converts a received optical signal to an electric signal which is transmitted by the radio station as a radio signal,
**characterized in** that the optical transmitter comprises a fiber ring (12) in which a rare-earth-doped section of fiber (13), two optical couplers (11, 19) and an optical filter arrangement (21) are inserted, that the first optical coupler (11) couples light emitted by a pump laser (9) into the fiber ring (12), that the optical filter arrangement (21) has two passbands for different frequencies (f₁, f₂), that the second optical coupler (19) couples light transmitted by the optical filter arrangement (21) from the fiber ring (12), and that the fiber ring (12) includes polarization-sensitive means (15) which excite natural modes (30, 31) orthogonal to the polarization, the natural modes (30, 31) being assigned said different frequencies (f₁, f₂), whose difference corresponds to an intermediate frequency (Δf) lying in the microwave region and serving as a carrier frequency for the radio signal.

3. An optical transmitter as claimed in claim 1 or a communications system as claimed in claim 2, characterized in that the polarization-sensitive means (15) are at least one polarization-maintaining optical waveguide (11, 13, 16, 19, 25, 26, 27, 28) of the fiber ring (12).

4. An optical transmitter as claimed in claim 1 or a communications system as claimed in claim 2, characterized in that the frequency-band-determining optical waveguide (13) is doped, particularly with erbium (Er³⁺).

5. An optical transmitter as claimed in claim 1 or a communications system as claimed in claim 2, characterized in that the optical filter arrangement (21) comprises two filters (23, 24) which are arranged in parallel in the fiber ring (12).

6. An optical transmitter as claimed in claim 1 or a communications system as claimed in claim 2, characterized in that the optical filter arragement (21) comprises a filter (34) with a free spectral range which corresponds to the difference (Δf) of the two frequencies (f₁, f₂).

7. An optical transmitter as claimed in claim 1 or a communications system as claimed in claim 2, characterized in that the optical filter arrangement has a prefilter (29) associated therewith which is contained in the fiber ring (12) and whose bandwidth includes the two passbands of the filter arrangement (21).

8. An optical transmitter as claimed in claim 1 or a communications system as claimed in claim 2, characterized in that the fiber ring (12) contains a polarization controller (17).

9. An optical transmitter as claimed in claim 1 or a communications system as claimed in claim 2, characterized in that the the fiber ring (12) contains a polarization-insensitive isolator (18).

10. An optical transmitter as claimed in claim 1 or a communications system as claimed in claim 2, characterized in that the fiber ring (12) contains a wavelength-dependent gain-matching element.

## Revendications

1. Dispositif d'émission optique dans lequel une fibre (13) dopée avec des ions des terres rares, deux coupleurs optiques (11, 19) et un système de filtrage optique (21) sont intégrés dans un anneau de fibres (12), dans lequel le premier coupleur optique (11) couple dans l'anneau de fibres (12) de la lumière émise par un laser de pompage (9), dans lequel le dispositif de filtrage optique (21) comprend deux zones de passage pour des fréquences différentes (f₁, f₂) et dans lequel le deuxième coupleur optique (19) découple de l'anneau de fibres (12) la lumière ayant passé par le système de filtrage optique (21), caractérisé en ce que dans l'anneau de fibres (12) sont disposés des moyens (15) sensibles à la polarisation qui produisent des modes propres (30, 31) orthogonaux par rapport à la polarisation, lesdites fréquences différentes (f₁, f₂), dont la différence de fréquence correspond à une fréquence intermédiaire (Δf) se trouvant dans la zone des hyperfréquences, étant associées aux modes propres (30, 31).

2. Système de transmission d'informations dans lequel un dispositif d'émission optique central est relié par des fibres optiques à au moins une station radio éloignée dudit dispositif, dans lequel est prévu dans la station radio un récepteur optique qui convertit un signal optique reçu en un signal électrique émis par la station radio comme signal radio, caractérisé en ce que le dispositif d'émission optique comporte un anneau de fibres (12) dans lequel sont insérés une fibre (13) dopée avec des ions des terres rares, deux coupleurs optiques (11, 19) et un système de filtrage optique (21), en ce que le premier coupleur optique (11) couple dans l'anneau de fibres (12) de la lumière émise par un laser de pompage (9), en ce que le dispositif de filtrage optique (21) comprend deux zones de passage pour des fréquences différentes (f₁, f₂), en ce que le deuxième coupleur optique (19) découple de l'anneau de fibres (12) la lumière ayant passé par le système de filtrage optique (21), et en ce que dans l'anneau de fibres (12) sont disposés des moyens (15) sensibles à la polarisation qui produisent des modes propres (30, 31) orthogonaux par rapport à la polarisation, lesdites fréquences différentes (f₁, f₂), dont la différence de fréquence correspond à une fréquence intermédiaire (Δf) se trouvant dans la zone des hyperfréquences et servant de fréquence porteuse pour le signal radio, étant associées aux modes propres (30, 31).

3. Dispositif d'émission optique suivant la revendication 1, ou système de transmission d'informations suivant la revendication 2, caractérisé en ce que les moyens (15) sensibles à la polarisation sont au moins une fibre optique (11, 13, 16, 25, 26, 27, 28), recevant la polarisation, de l'anneau de fibres (12).

4. Dispositif d'émission optique suivant la revendication 1, ou système de transmission d'informations suivant la revendication 2, caractérisé en ce que la fibre optique (13) déterminant la bande de fréquences présente un dopage, en particulier un dopage à l'erbium (Er³⁺).

5. Dispositif d'émission optique suivant la revendication 1, ou système de transmission d'informations suivant la revendication 2, caractérisé en ce que le système de filtrage optique (21) présente deux filtres (23, 24) disposés dans l'anneau de fibres (12) en circuit parallèle l'un à l'autre.

6. Dispositif d'émission optique suivant la revendication 1, ou système de transmission d'informations suivant la revendication 2, caractérisé en ce que le dispositif de filtrage optique (21) comporte un filtre (34) ayant un domaine spectral libre (FST) correspondant à la différence (Δf) des deux fréquences (f₁, f₂).

7. Dispositif d'émission optique suivant la revendication 1, ou système de transmission d'informations suivant la revendication 2, caractérisé en ce qu'un pré-filtre (29) placé dans l'anneau de fibres (12) est associé au système de filtrage optique, les deux zones de passage du système de filtrage (21) étant comprises dans la largeur de bande dudit pré-filtre.

8. Dispositif d'émission optique suivant la revendication 1, ou système de transmission d'informations suivant la revendication 2, caractérisé en ce qu'un polariscope (17) est disposé dans l'anneau de fibres (12).

9. Dispositif d'émission optique suivant la revendication 1, ou système de transmission d'informations suivant la revendication 2, caractérisé en ce qu'un isolateur (18) insensible à la polarisation est disposé dans l'anneau de fibres (12).

10. Dispositif d'émission optique suivant la revendication 1, ou système de transmission d'informations suivant la revendication 2, caractérisé en ce qu'un élément d'adaptation d'amplification dépendant de la longueur d'onde est disposé dans l'anneau de fibres (12).
